(19) **Europäisches Patentamt**
**European Patent Office**
**Office européen des brevets**

(11) **EP 3 570 437 B1**

(12) **EUROPÄISCHE PATENTSCHRIFT**

(45) Veröffentlichungstag und Bekanntmachung des Hinweises auf die Patenterteilung:
**27.12.2023 Patentblatt 2023/52**

(21) Anmeldenummer: **18172430.3**

(22) Anmeldetag: **15.05.2018**

(51) Internationale Patentklassifikation (IPC):
***H03F 3/45*** (2006.01)

(52) Gemeinsame Patentklassifikation (CPC):
**H03F 3/45475; H03F 3/45928;** H03F 2200/261;
H03F 2203/45101; H03F 2203/45138;
H03F 2203/45526; H03F 2203/45586

(54) **SCHALTUNGSANORDNUNG ZUR ERZEUGUNG EINER VERSORGUNGSSPANNUNG MIT STEUERBAREM MASSEPOTENTIALNIVEAU**

CIRCUIT ASSEMBLY FOR GENERATING A SUPPLY VOLTAGE WITH CONTROLLABLE MASS POTENTIAL LEVEL

ENSEMBLE DE CIRCUIT PERMETTANT DE PRODUIRE UNE TENSION D'ALIMENTATION À NIVEAU DE POTENTIEL DE MASSE COMMANDABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**20.11.2019 Patentblatt 2019/47**

(73) Patentinhaber: **Siemens Aktiengesellschaft 80333 München (DE)**

(72) Erfinder:
• **Kreb, Walter**
  **76848 Schwanheim (DE)**
• **Griesbaum, Wilhelm**
  **76829 Landau (DE)**
• **Lehmann, Ulrich**
  **76744 Wörth (DE)**

(74) Vertreter: **Siemens Patent Attorneys Postfach 22 16 34 80506 München (DE)**

(56) Entgegenhaltungen:
**JP-A- 2004 214 712     US-A- 4 704 575**

• **JIM WILLIAMS: "COMPOSITE AMPLIFIERS YIELD HIGH SPEED AND LOW OFFSET", EDN ELECTRICAL DESIGN NEWS.(TEXAS INSTRUMENT), REED BUSINESS INFORMATION, HIGHLANDS RANCH, CO, US, Bd. 32, Nr. 2, 22. Januar 1987 (1987-01-22), Seiten 139-150, XP002163314, ISSN: 0012-7515**

**EP 3 570 437 B1**

**Beschreibung**

Die Erfindung betrifft eine Schaltungsanordnung zur Erzeugung einer Versorgungsspannung mit steuerbarem Massepotentialniveau.

Messverstärker, z. B. Instrumentenverstärker, mit differentiellem Eingang (Differenzverstärker) haben einen begrenzten Gleichtakt-Eingangsspannungsbereich. Dieser hängt auch von der Höhe der Versorgungsspannung der Eingangsstufen ab, die oft mit Operationsverstärkern realisiert sind. In der Regel können die Eingangsspannungen an den Operationsverstärker-Eingängen nicht über der Versorgungsspannung des Operationsverstärkers liegen. Für Messbereiche mit sowohl hoher positiver als auch mit hoher negativer Gleichtakt-Eingangsspannung erfordert dies Operationsverstärker-Stufen mit hoher bipolarer Spannungsversorgung. Operationsverstärker mit maximalen Versorgungsspannungen oberhalb von $\pm 20$ V sind jedoch teuer, haben oft nicht die gewünschten Eigenschaften in Bezug auf Rauschen und Offsetspannung und verursachen wegen der hohen Versorgungsspannungen entsprechend hohe Verlustleistung.

Bisher wird, wie erwähnt, mit hoher positiver und negativer Versorgungsspannung der Operationsverstärker gearbeitet oder die Eingangsspannungen werden über Spannungsteiler reduziert. Ebenso ist es bekannt, zwischen unterschiedlichen Versorgungsspannungen umzuschalten oder potentialgetrennte Lösungen vorzusehen, was jedoch bei mehrkanaligen Systemen mit hohem Aufwand verbunden ist.

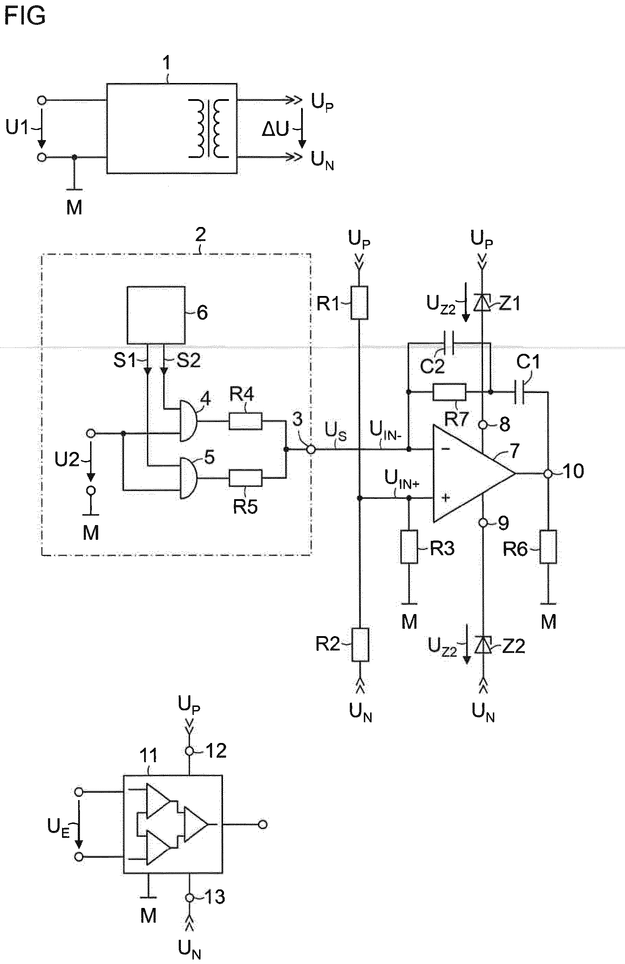

Aus der JP 2004 214712 A, insbesondere der dortigen Fig. 11, ist eine Anti-Pop-Schaltung für einen Verstärker mit Stummschaltung bekannt. Der Verstärker enthält einen Operationsverstärker mit einem die Verstärkung A bestimmenden Rückkopplungswiderstand und einer Rückkopplungskapazität in invertierender Verstärkerschaltung. Der Operationsverstärker ist mit seinen Spannungsversorgungsanschlüssen an einer Spannungsquelle zwischen einem Versorgungsspannungpotential VDD2 und Masse angeschlossen und erhält an seinem invertierenden Eingang ein zu verstärkendes Eingangssignal ei, das zwischen einem maximalen Spannungswert VDD1 und Null (Masse) um den Mittelwert ½ · VDD1 variiert. Der nicht-invertierende Eingang des Operationsverstärkers ist über ein umschaltbares Widerstandsnetzwerk mit dem Versorgungsspannungpotential VDD2 der Spannungsquelle, einem Referenzspannungpotential mit dem Wert VDD1 sowie dem Masseanschluss verbunden. Mit Hilfe des umschaltbaren Widerstandsnetzwerks wird in Anhängigkeit von dem Verstärkungsfaktor A das Spannungsniveau am Ausgang des Operationsverstärkers so eingestellt, dass dessen Ausgangsspannung im Verstärkungsbetrieb den Mittelwert ½ · VDD2 hat und diesen Wert beim Stummschalten (A = 0) beibehält. Falls die Referenzspannung VDD1 eine Restwelligkeit ΔVDD1 aufweist, kann diese durch eine dem Eingangssignal überlagerte Brummspannung ½ · ΔVDD1 kompensiert werden, die mit Hilfe eines 1-bit D/A-Wandlers (PRZ) erzeugt wird.

Von einer Erzeugung einer Versorgungsspannung mit steuerbarem Massepotentialniveau ist in der JP 2004 214712 A keine Rede.

Der Erfindung liegt daher die Aufgabe zugrunde, eine Versorgungsspannung, beispielsweise und insbesondere für Differenzverstärker, mit einstellbarem Massepotentialniveau.

Gemäß der Erfindung wird die Aufgabe durch die in Anspruch 1 definierte Schaltungsanordnung gelöst, von der vorteilhafte Weiterbildungen in den Unteransprüchen angegeben sind.

Gegenstand der Erfindung ist somit eine Schaltungsanordnung zur Erzeugung einer Versorgungsspannung mit steuerbarem Massepotentialniveau

- mit einer Spannungsquelle, die die Versorgungsspannung als Differenz von zwei Versorgungsspannungspotentialen massefrei, d. h. potentialgetrennt von Masse, bereitstellt,
- mit einer Steuereinheit, die eine einstellbare Steuerspannung gegen Masse erzeugt, und
- mit einem Operationsverstärker,

  - der mit seinen Spannungsversorgungsanschlüssen an den Versorgungsspannungspotentialen der Spannungsquelle angeschlossen ist,
  - an dessen invertierendem Eingang die Steuerspannung anliegt,
  - dessen nicht-invertierender Eingang über ein Widerstandsnetzwerk mit den Versorgungsspannungspotentialen der Spannungsquelle und mit einem Masseanschluss verbunden ist und
  - dessen Ausgang über eine Kapazität an den invertierenden Eingang rückgekoppelt ist, wobei zwischen dem Ausgang (10) des Operationsverstärkers und seinem invertierenden Eingang ein Widerstand in Reihe mit der Kapazität liegt.

Die Erfindung basiert auf der Verwendung einer potentialgetrennten Versorgungsspannung für den Operationsverstärker, wobei das Potential dieser Versorgungsspannung gegenüber Masse mittels der Steuerspannung und über die Rückkopplung des Operationsverstärkers aktiv gesteuert wird. Der Eingangs-Gleichtaktbereich eines versorgungsseitig an der Spannungsquelle und Masse angeschlossenen Differenzverstärkers lässt sich dann innerhalb eines Bereichs bewegen, dessen obere und untere Grenze, zumindest theoretisch, dem positiven bzw. negativen Betrag der Versorgungsspannung entspricht.

Zur weiteren Erläuterung der Erfindung wird im Folgenden auf die einzige Figur der Zeichnung Bezug genommen, die ein Ausführungsbeispiel der erfindungsgemäßen Schaltungsanordnung in vereinfachter schematischer Darstellung zeigt.

Eine Spannungsquelle 1, hier z. B. in Form eines Gleichspannungswandlers mit galvanischer Trennung von Eingangs- und Ausgangsseite, erzeugt aus einer Eingangsspannung U1 eine Ausgangspannung und stellt diese als Versorgungsspannung $\Delta U$ potentialgetrennt von der Masse M zur Verfügung. Die Versorgungsspannungspotentiale $U_P$ und $U_N$ ($\Delta U = U_P - U_N$) sind also zunächst undefiniert.

Es soll daher eine steuerbare Einstellung des Massepotentialniveaus der Versorgungsspannung ($\Delta U$) bzw. der Versorgungsspannungspotentiale $U_P$ und $U_N$ gegenüber der Masse M in Anhängigkeit von einer Steuerspannung $U_S$ (gegen Masse M) erfolgen. Die Steuerspannung $U_S$ kann auf unterschiedlichste Weise von einer Steuereinheit 2 an ihrem Steuerausgang 3 erzeugt werden. Bei dem dargestellten Beispiel wird sie als Mittelwert von zwei einzeln ein- und ausschaltbaren, hier gleichen, Festspannungen erzeugt, indem eine Logikspannung U2, z. B. eine TTL- oder LVTTL-Versorgungsspannung, mit Hilfe von zwei UND-Gattern 4, 5 in Abhängigkeit von zwei logischen Steuersignalen S1, S2 und über Widerstände R4 und R5 an den Steuerausgang 3 geschaltet wird. Die Steuersignale S1, S2 werden von einer Recheneinrichtung 6, z. B. CPU, erzeugt, so dass sich beispielsweise im Falle von R4 = R5 drei unterschiedliche Werte der Steuerspannung $U_S$ erzeugen lassen:

| S1 | S2 | $U_S$ |
|----|----|----|
| 0 | 0 | 0 |
| 1 | 0 | ½ U2 |
| 1 | 1 | U2 |

In einer besonders einfach zu realisierenden Alternative können die Logikpegel U2 und 0 V beispielsweise über ein Schieberegister unmittelbar an die Widerstände R4 und R5 ausgegeben werden.

Die Steuerspannung $U_S$ liegt unmittelbar an dem invertierenden Eingang (-) eines Operationsverstärkers 7, der mit seinen Spannungsversorgungsanschlüssen 8, 9 entweder direkt oder, wie hier gezeigt, zur Reduzierung der Verlustleistung an dem Operationsverstärker 7 über Zenerdioden Z1, Z2 an der Spannungsquelle 1 angeschlossen ist, so dass an dem Spannungsversorgungsanschluss 8 das um die Zenerspannung $U_{Z1}$ verminderte Versorgungsspannungspotential $U_P$ und an dem Spannungsversorgungsanschluss 9 das um die Zenerspannung $U_{Z2}$ verminderte Versorgungsspannungspotential $U_N$ anliegt.

Der nicht-invertierender Eingang (+) des Operationsverstärkers 7 ist über ein Widerstandsnetzwerk R1, R2, R3 mit der Spannungsquelle 1 und mit der Masse M verbunden. In dem hier gezeigten einfachsten Fall ist der nicht-invertierende Eingang (+) über den Widerstand R1 mit dem Versorgungsspannungspotential $U_P$, über den Widerstand R2 mit dem Versorgungsspannungspotential $U_N$ und über den Widerstand R3 mit Masse M verbunden. Der Ausgang 10 des Operationsverstärkers 7 ist über eine Kapazität C1 und optional einen Widerstand R7 mit ggf. paralleler Kapazität C2 an den invertierenden Eingang (-) rückgekoppelt. Der Operationsverstärker 7 arbeitet somit als I-Regler bzw. PI-Regler ohne bleibende Regelabweichung; d. h. es fließt kein die Steuerspannung $U_S$ beeinflussender Gleichstrom vom Ausgang 10 des Operationsverstärkers 7 durch die Widerstände R4 und R5. Schließlich kann der Ausgang 10 des Operationsverstärkers 7 über einen Widerstand R6 z. B. niederohmig mit Masse verbunden sein.

Für die Spannung $U_{IN+}$ zwischen dem nicht-invertierenden Eingang (+) des Operationsverstärkers 7 und Masse M gilt:

$$U_{IN+} = U_P \cdot \frac{R2||R3}{R1 + R2||R3} + U_N \cdot \frac{R1||R3}{R2 + R1||R3}$$

$$= U_P \cdot \frac{R2 \cdot R3}{R1 \cdot R2 + R1 \cdot R3 + R2 \cdot R3} + U_N \cdot \frac{R1 \cdot R3}{R1 \cdot R2 + R1 \cdot R3 + R2 \cdot R3} \ .$$

$U_P$ und $U_N$ sind die gegenüber Masse M einzustellenden Versorgungsspannungspotentiale. Ferner gilt aufgrund der I- bzw. PI-Rückkopplung des Operationsverstärkers 7 für die Spannung $U_{IN-}$ zwischen dem invertierenden Eingang (+) des Operationsverstärkers 7 und Masse M: $U_{IN-} = U_{IN+} = U_S$. Mit $\Delta U = U_P - U_N$ erhält man daher:

$$U_P = U_S \cdot \left(1 + \frac{R1 \cdot R2}{R1 \cdot R3 + R2 \cdot R3}\right) + \Delta U \cdot \frac{R1}{R1 + R2}$$

und

$$U_N = U_S \cdot \left(1 + \frac{R1 \cdot R2}{R1 \cdot R3 + R2 \cdot R3}\right) - \Delta U \cdot \frac{R2}{R1 + R2} \quad .$$

Es seien beispielsweise $\Delta U$ = 30 V und U2 = 3,3 V. Mit R4 = R5, R1 = 200 k$\Omega$, R2 = 1 M$\Omega$ und R3 = 33 k$\Omega$ lassen sich in Abhängigkeit von den Steuersignalen S1, S2 folgende Versorgungsspannungspotentiale $U_P$ und $U_N$ gegenüber Masse M einstellen:

| S1 | S2 | $U_S$ | $U_P$ | $U_N$ |
|----|----|-------|-------|-------|
| 0 | 0 | 0 | 5 V | -25 V |
| 1 | 0 | 1,65 V | 15 V | -15 V |
| 1 | 1 | 3,3 V | 25 V | -5 V |

Da bei dem gezeigten Beispiel der höchste Absolutwert für $U_P$ und $U_N$ jeweils 25 V beträgt, können die zur Reduzierung der Verlustleistung an dem Operationsverstärker 7 dienenden Zenerdioden Z1, Z2 Zenerspannungen von typischerweise 4,3 V aufweisen. Von externen Störungen wie z. B. Bursts hervorgerufene unerwünschte Abweichungen des Massepotentialniveaus werden den reduzierten Ausgangsspannungsbereich des Operationsverstärkers 7 begrenzt. Zu dieser Begrenzung kann auch der Widerstand R6 am Ausgang 10 des Operationsverstärkers 7 beitragen.

Bei dem gezeigten Ausführungsbeispiel ist ein Differenzverstärker 11, z. B. ein Instrumentenverstärker, mit seinen Spannungsversorgungsanschlüssen 12, 13 an der Spannungsquelle 1 angeschlossen und ferner mit dem Masseanschluss M verbunden. Über die Steuerspannung $U_S$ kann der theoretisch $\Delta U$ betragende Gleichtaktbereich der Eingangsspannung $U_E$ des Differenzverstärkers 11 zwischen +|$\Delta U$| und -|$\Delta U$| verschoben werden.


**Patentansprüche**

**1.**   Schaltungsanordnung zur Erzeugung einer Versorgungsspannung ($\Delta U$) mit steuerbarem Massepotentialniveau

- mit einer Spannungsquelle (1), die die Versorgungsspannung ($\Delta U$) als Differenz von zwei Versorgungsspannungspotentialen ($U_P$, $U_N$) massefrei bereitstellt,
- mit einer Steuereinheit (2), die eine einstellbare Steuerspannung ($U_S$) gegen Masse (M) erzeugt, und
- mit einem Operationsverstärker (7),

- der mit seinen Spannungsversorgungsanschlüssen (8, 9) an den Versorgungsspannungspotentialen ($U_P$, $U_N$) der Spannungsquelle (1) angeschlossen ist,
- an dessen invertierendem Eingang (-) die Steuerspannung ($U_S$) anliegt,
- dessen nicht-invertierender Eingang (+) über ein Widerstandsnetzwerk (R1, R2, R3) mit den Versorgungsspannungspotentialen ($U_P$, $U_N$) der Spannungsquelle (1) und mit einem Masseanschluss (M) verbunden ist und
- dessen Ausgang (10) über eine Kapazität (C1) an den invertierenden Eingang (-) rückgekoppelt ist, wobei zwischen dem Ausgang (10) des Operationsverstärkers (7) und seinem invertierenden Eingang (-) ein Widerstand (R7) in Reihe mit der Kapazität (C1) liegt.

**2.**   Schaltungsanordnung nach Anspruch 1, **dadurch gekennzeichnet, dass** die Steuereinheit (2) dazu ausgebildet ist, die Steuerspannung ($U_S$) als Mittelwert von mindestens zwei einzeln ein- und ausschaltbaren Festspannungen (U2) zu erzeugen.

**3.**   Schaltungsanordnung nach einem der vorangehenden Ansprüche, **dadurch gekennzeichnet, dass** der Operationsverstärker (7) mit seinen Versorgungsanschlüssen (8, 9) über Zenerdioden (Z1, Z2) an den Versorgungsspannungspotentialen ($U_P$, $U_N$) der Spannungsquelle (1) angeschlossen ist.

4. Schaltungsanordnung nach einem der vorangehenden Ansprüche, **dadurch gekennzeichnet, dass** die Spannungsquelle (1) als Gleichspannungswandler mit galvanischer Trennung von Eingangs- und Ausgangsseite ausgebildet ist.

5. Schaltungsanordnung nach einem der vorangehenden Ansprüche, **dadurch gekennzeichnet, dass** ein Differenzverstärker (11) mit seinen Spannungsversorgungsanschlüssen (12, 13) an den Versorgungsspannungspotentialen ($U_P$, $U_N$) der Spannungsquelle (1) angeschlossen ist und ferner mit dem Masseanschluss (M) verbunden ist.

**Claims**

1. Circuit arrangement for generating a supply voltage ($\Delta U$) with a controllable ground potential level

   - with a voltage source (1) which provides the supply voltage ($\Delta U$) ungrounded as a difference between two supply voltage potentials ($U_P$, $U_N$),
   - with a control unit (2) which generates an adjustable control voltage ($U_S$) to ground (M), and
   - with an operational amplifier (7),

      - which is connected by its voltage supply terminals (8, 9) to the supply voltage potentials ($U_P$, $U_N$) of the voltage source (1),
      - to the inverting input (-) of which the control voltage ($U_S$) is applied,
      - the non-inverting input (+) of which is connected via a resistor network (R1, R2, R3) to the supply voltage potentials ($U_P$, $U_N$) of the voltage source (1) and to a ground terminal (M) and
      - the output (10) of which is fed back to the inverting input (-) via a capacitor (C1), wherein a resistor (R7) lies in series with the capacitor (C1) between the output (10) of the operational amplifier (7) and its inverting input (-).

2. Circuit arrangement according to claim 1, **characterised in that** the control unit (2) is designed to generate the control voltage ($U_S$) as an average value of at least two individually activatable and deactivatable fixed voltages (U2).

3. Circuit arrangement according to one of the preceding claims, **characterised in that** the operational amplifier (7) is connected by its supply terminals (8, 9) via Zener diodes (Z1, Z2) to the supply voltage potentials ($U_P$, $U_N$) of the voltage source (1).

4. Circuit arrangement according to one of the preceding claims, **characterised in that** the voltage source (1) is designed as a d.c. - d.c. converter with electrical isolation of the input and output side.

5. Circuit arrangement according to one of the preceding claims, **characterised in that** a differential amplifier (11) is connected by its voltage supply terminals (12, 13) to the supply voltage potentials ($U_P$, $U_N$) of the voltage source (1) and is further connected to the ground terminal (M).

**Revendications**

1. Montage de production d'une tension ($\Delta U$) d'alimentation ayant un niveau de potentiel de masse pouvant être commandé,

   - comprenant une source (1) de tension, qui donne, sans masse, la tension ($\Delta U$) d'alimentation sous la forme d'une différence de deux potentiels ($U_P$, $U_N$) de tension d'alimentation,
   - comprenant une unité (2), qui produit vis-à-vis de la masse (M), une tension ($U_S$) de commande réglable, et
   - comprenant un amplificateur (7) opérationnel,

      - qui est raccordé, par ses bornes (8, 9) d'alimentation en tension, aux potentiels ($U_P$, $U_N$) de tension d'alimentation de la source (1) de tension,
      - à l'entrée (-) inverseuse duquel s'applique la tension ($U_S$) de commande,
      - dont l'entrée (+) non inverseuse est reliée par un réseau (R1, R2, R3) de résistance aux potentiels ($U_P$,

U$_N$) de tension d'alimentation de la source (1) d'alimentation et à une borne (M) de masse, et

- dont la sortie (10) est reliée en réaction à l'entrée (-) inverseuse par une capacité (C1), dans lequel une résistance (R7) est montée en série avec la capacité (C1) entre la sortie (10) de l'amplificateur (7) opérationnel et son entrée (-) inverseuse.

2. Montage suivant la revendication 1, **caractérisé en ce que** l'unité (2) de commande est constituée pour produire la tension (U$_S$) de commande comme valeur moyenne d'au moins deux tensions (U2) fixes individuelles pouvant être mises en circuit et hors circuit.

3. Montage suivant l'une des revendications précédentes, **caractérisé en ce que** l'amplificateur (7) opérationnel est raccordé par ses bornes (8, 9) d'alimentation, par l'intermédiaire de diodes (Z1, Z2) Zener, aux potentiels (U$_P$, U$_N$) de tension d'alimentation de la source (1) de tension.

4. Montage suivant l'une des revendications précédentes, **caractérisé en ce que** la source (1) de tension est constituée sous la forme d'un convertisseur de tension continue avec séparation galvanique du côté d'entrée et du côté de sortie.

5. Montage suivant l'une des revendications précédentes, **caractérisé en ce qu'**un amplificateur (11) différentiel est relié par ses bornes (12, 13) d'alimentation en tension aux potentiels (U$_P$, U$_N$) de tension d'alimentation de la source (1) d'alimentation et est relié en outre à la borne (M) de masse.

FIG

EP 3 570 437 B1

7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2004214712 A